# EUROPEAN PATENT APPLICATION

(11) **EP 4 113 838 A1**
(43) Date of publication of application: **04.01.2023**
(21) Application number: 20898856.8
(22) Date of filing: 06.05.2020
(51) Int. Cl.: H03H 9/15

(54) **BULK ACOUSTIC WAVE RESONATOR WITH ELECTRODE HAVING VOID LAYER, FILTER AND ELECTRONIC DEVICE**

(30) Priority: 11.12.2019 CN 201911266563
(71) Applicant: Rofs Microsystem (Tianjin) Co., Ltd, Tianjin 300462 (CN)
(72) Inventor: PANG, Wei, Tianjin 300072 (CN); HAO, Long, Tianjin 300072 (CN); XU, Yang, Tianjin 300072 (CN); ZHANG, Wei, Tianjin 300072 (CN); ZHANG, Menglun, Tianjin 300072 (CN); YANG, Qingrui, Tianjin 300072 (CN)
(74) Representative: Bandpay & Greuter
(86) International application number: PCT/CN2020/088700
(87) International publication number: WO 2021/114555

(57) **Abstract**

The present disclosure relates to a bulk acoustic wave resonator, including: a base; an acoustic mirror; a bottom electrode; a top electrode; and a piezoelectric layer arranged between the bottom electrode and the top electrode, wherein: the bottom electrode and/or the top electrode is gap electrode, the gap electrode has a void layer, the upper side of the void layer has an upper electrode layer, the lower side of the void layer has a lower electrode layer, the void layer is arranged between the upper electrode layer and the lower electrode layer in the thickness direction of the resonator, the upper electrode layer and the lower electrode layer are electrically connected in parallel with each other at both ends of the void layer; one electrode layer of the upper electrode layer and the lower electrode layer is an arc-shaped electrode layer having a radian away from the other electrode layer of the upper electrode layer and the lower electrode layer in the thickness direction of the resonator. The present disclosure further relates to a filter having the above resonator and an electronic device having the filter or the resonator.

## Description

### TECHNICAL FIELD

Embodiments of the disclosure relate to the field of semiconductors, and in particular, to a bulk acoustic wave resonator, a filter with the resonator, and an electronic device with the resonator or the filter.

### BACKGROUND

As basic elements of an electronic apparatus, electronic devices have been widely applied, and their applications cover mobile phones, automobiles, home appliances and the like. In addition, technologies such as artificial intelligence, Internet of Things and 5G communication that will change the world in the future still need and rely on the electronic devices.

As an important member of the piezoelectric devices, a Film Bulk Acoustic Resonator (FBAR, also referred to as a bulk acoustic wave resonator (BAW)) is very important in the field of communication, and especially, an FBAR filter has gained a growing market share in the field of radio frequency filters. The traditional surface acoustic wave (SAW) filters and ceramic filters are gradually replaced by the FBAR filters due to their small dimension, high resonant frequency, high quality factor, large power capacity, good roll-off effect, and other excellent characteristics. Such the FBAR filters are used widely in the field of wireless communication radio frequency, and can be also applicable to the sensing filed such as biology, physics, and medicine due to their high sensitivity.

The film bulk acoustic resonator mainly includes a "sandwich" structure composed of electrode-piezoelectric film-electrode, i.e., the piezoelectric material is sandwiched between the two metal electrodes. When a sinusoidal signal is input between the two electrodes, the FBAR converts an input electrical signal into a mechanical resonance through an inverse piezoelectric effect, and then converts the mechanical resonance into an electrical signal output by the piezoelectric effect.

The rapid development of communication technologies requires a continuous increase in the working frequency of a filter. For example, the frequency of a 5G communication frequency band (sub-6G) is between 3 GHz and 6 GHz, which is higher than that of 4G and other communication technologies. As for the bulk acoustic wave resonator and the filter, the high working frequency means that the film thickness, especially the film thickness of an electrode, needs to be further reduced. However, a main negative effect caused by the decrease in the film thickness of the electrode is a decrease in a Q value of the resonator resulting from an increase in the electrical loss, especially a decrease in the Q value at a series resonance point and its nearby frequencies. Correspondingly, the performance of a bulk acoustic wave filter with a high working frequency is greatly deteriorated with the decrease in the Q value of the bulk acoustic wave resonator.

### SUMMARY

In order to alleviate or solve at least one aspect of the above problems in the related art, the present disclosure is provided.

According to an aspect of embodiments of the present disclosure, there is provided a bulk acoustic wave resonator, which includes a substrate, an acoustic mirror, a bottom electrode, a top electrode, and a piezoelectric layer provided between the bottom electrode and the top electrode. The bottom electrode and/or the top electrode is a gap electrode, and the gap electrode has a gap layer. The gap layer is provided with an upper electrode layer on an upper side thereof and a lower electrode layer on a lower side thereof. The gap layer is arranged between the upper electrode layer and the lower electrode layer in a thickness direction of the resonator, and the upper electrode layer and the lower electrode layer are electrically connected to each other in parallel at both ends of the gap layer. One of the upper electrode layer and the lower electrode layer is an arc-shaped electrode layer, and the arc-shaped electrode layer has a radian away from another one of the upper electrode layer and the lower electrode layer in the thickness direction of the resonator.

An embodiment of the present disclosure also relates to a filter including the bulk acoustic wave resonator described above.

An embodiment of the present disclosure also relates to an electronic device including the filter or the resonator described above.

### BRIEF DESCRIPTION OF DRAWINGS

The following description and drawings can facilitate to understand these and other features and advantages in various embodiments disclosed in the present disclosure. The same reference signs in the drawings always indicate the same components.
FIG. 1 is a schematic top view of a bulk acoustic wave resonator according to an exemplary embodiment of the present disclosure.
FIG. 2 is a schematic sectional view along line A1-A2 in FIG. 1 according to an exemplary embodiment of the present disclosure, in which top electrodes are provided with a gap layer and an upper electrode layer of the top electrodes protrudes upwardly.
FIG. 3 is a schematic sectional view along line A1-A2 in FIG. 1 according to another exemplary embodiment of the present disclosure, in which top electrodes are provided with a gap layer and a lower electrode layer of the top electrodes protrudes downwardly.
FIG. 4 is a schematic sectional view along line A1-A2 in FIG. 1 according to an exemplary embodiment of the present disclosure, in which bottom electrodes are both provided with a gap layer and a lower electrode layer of the bottom electrodes protrudes downwardly.
FIG. 5 is a schematic sectional view along line A1-A2 in FIG. 1 according to an exemplary embodiment of the present disclosure, in which bottom electrodes are both provided with a gap layer and an upper electrode layer of the bottom electrodes protrudes upwardly.
FIG. 6 is a schematic sectional view along line A1-A2 in FIG. 1 according to an exemplary embodiment of the present disclosure, in which bottom electrodes are both provided with a gap layer as an acoustic mirror structure, and an upper electrode layer of the bottom electrodes protrudes upwardly.
FIG. 7 is a schematic sectional view along line A1-A2 in FIG. 1 according to an exemplary embodiment of the present disclosure, in which a bottom electrode and a top electrode are both provided with a gap layer.
FIG. 8 is a schematic diagram of possible contact between upper and lower electrode layers of a gap electrode.

### DESCRIPTION OF EMBODIMENTS

The technical solutions of the present disclosure will be further described in detail below through embodiments and in conjunction with the drawings. In the specification, the same or similar reference signs refer to the same or similar components. The following description of the embodiments of the present disclosure with reference to the drawings is intended to explain the general inventive concept of the present disclosure, and should not be construed as limitation to the present disclosure.

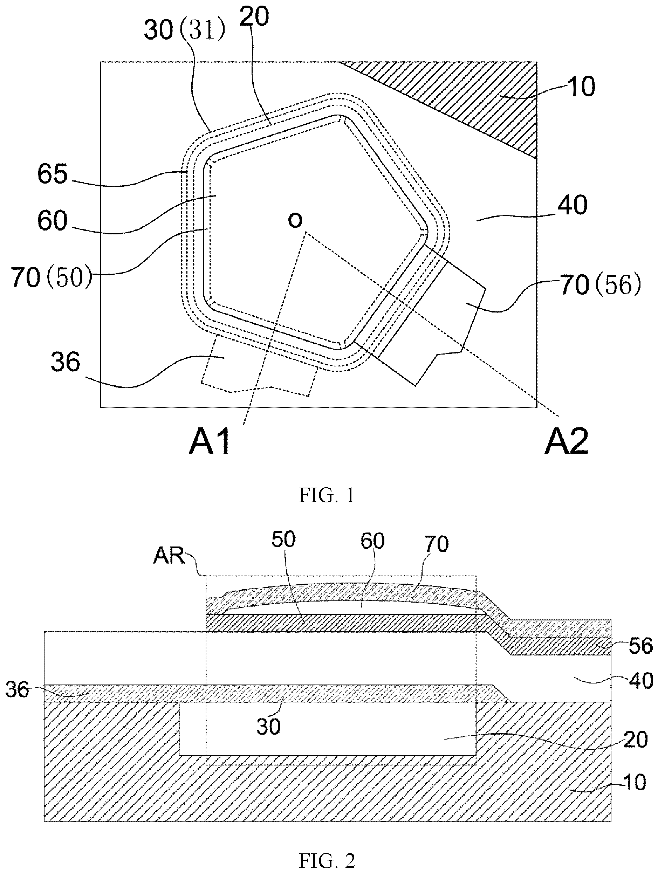

FIG. 1 is a schematic top view of a bulk acoustic wave resonator according to an exemplary embodiment of the present disclosure. In FIGS. 1, reference numbers are described as follows.

10 denotes a substrate, which may be made of a material such as silicon (high-resistivity silicon), gallium arsenide, sapphire, and quartz.

20 denotes an acoustic mirror, which is a cavity 20 in FIGS. 2 to 5, or may adopt a Bragg reflection layer and other equivalent forms.

30 denotes a first bottom electrode, which may be made of molybdenum, ruthenium, gold, aluminum, magnesium, tungsten, copper, titanium, iridium, osmium, chromium, or composite or alloys thereof.

36 denotes an electrode pin, of which a material is the same as that of the first bottom electrode.

31 denotes a second bottom electrode, of which a material is selected from the same range as that of the first bottom electrode 30, but the material of the second bottom electrode is not necessarily the same as that of the first bottom electrode 30.

40 denotes a piezoelectric film layer, which may be made of aluminum nitride (AlN), zinc oxide (ZnO), lead zirconate titanate (PZT), lithium niobate (LiNbO₃), quartz, potassium niobate (KNbO₃), or lithium tantalate (LiTaO₃), etc., and may contain the above materials doped with a certain atomic ratio of rare earth element.

50 denotes a first top electrode, which may be made of molybdenum, ruthenium, gold, aluminum, magnesium, tungsten, copper, titanium, iridium, osmium, chromium, or composite or alloys thereof.

56 denotes an electrode pin, which can be made of a material same as that of the first top electrode.

60 denotes an air gap, which is located in the top electrode and arranged between the first top electrode 50 and a second top electrode 70.

70 denotes the second bottom electrode, of which a material is selected from the same range as that of the first top electrode 50, but the material of the second bottom electrode is not necessarily the same as that of the first top electrode 50.

It should be noted that the air gap forms a gap layer. However, in the present disclosure, the gap layer may be a vacuum gap layer or a gap layer filled with other gas medium, in addition to the air gap layer.

The gap layer may be arranged in the top electrode, in the bottom electrode, or both in the top electrode and the bottom electrode. FIG. 1 shows an embodiment in which top electrodes and a bottom electrode are both provided with a gap layer.

FIG. 2 is a schematic sectional view along line A1-A2 in FIG. 1 according to an exemplary embodiment of the present disclosure, in which the top electrodes are provided with a gap layer and an upper electrode layer of the top electrodes protrudes upwardly.

As shown in FIG. 2, the resonator has double layers of the top electrodes 50, 70, i.e., the first top electrode 50 and the second top electrode 70. The top electrode 70 covers an entire upper surface of the top electrode 50 while the top electrode 70 keeps in contact with at the upper surface of the top electrode 50 at both a non-electrode pin side and a pin side thereof, thereby forming an air gap 60 between the top electrodes 70, 50.

When the resonator operates, an alternating electric field is applied to a piezoelectric layer 40 through the electrodes. Since acoustic energy and electrical energy are coupled and converted into each other, a current flows through the electrodes. The bottom electrode of this embodiment has a double-layered electrode parallel structure such that electrical loss of the resonator can be effectively reduced. The piezoelectric layer generates sound waves under excitation of the alternating electric field. When the sound waves are conducted upwardly to an interface between the gap layer 60 in the top electrodes and the electrode layer 50, energy of the sound waves is reflected back to the piezoelectric layer 40 because acoustic impedances of air and the electrodes are greatly mismatched. However, the energy of the sound waves cannot enter the electrode layer 70. On the one hand, the electrode structure containing the gap layer in the present disclosure can significantly reduce the electrical loss of the resonator, which is indicated by an improved Q value at and near a series resonance frequency. On the other hand, the air gap functions to acoustically isolate the top electrode 70 such that negative influence of the top electrode 70 on the resonator performance, such as resonance frequency and electromechanical coupling coefficient, can be substantially avoided.

Optionally, a height of the air gap is in a range of 50 Å to 10000 Å. Further, the height of the air gap is greater than a typical amplitude of the resonator (about 10 nm), for example, the height of the air gap is in a range of 100 Å to 5000 Å. This facilitates acoustic energy decoupling between the top electrode 70 and a resonant cavity when the resonator operates at a high power. In this embodiment, the resonant cavity is a composite structure formed by the top electrode 50, the piezoelectric layer 40, and the bottom electrode 30.

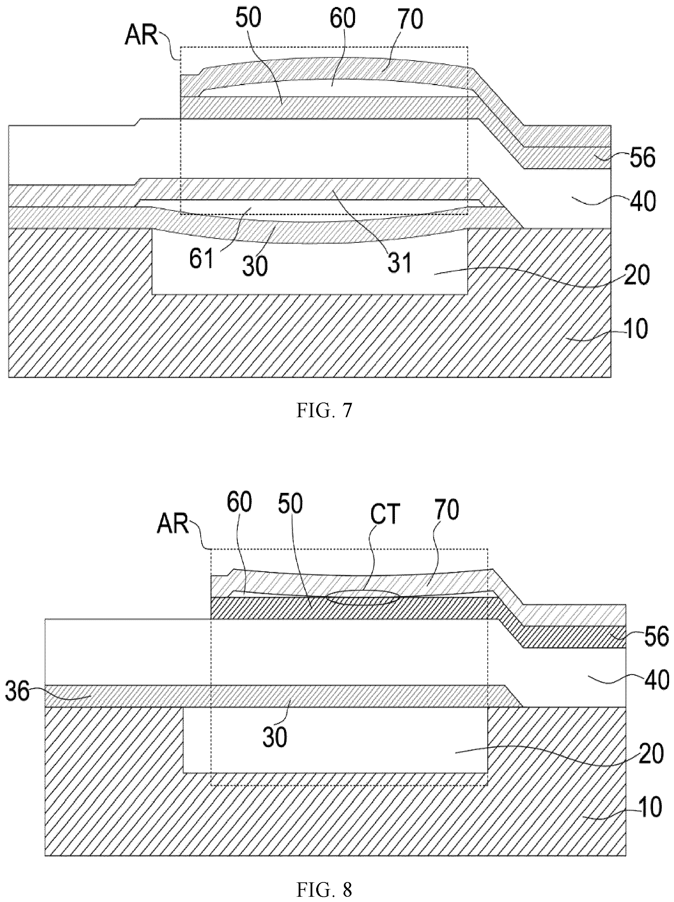

FIG. 8 is a schematic diagram of possible contact between upper and lower electrode layers of the gap electrode. The air gap structure is usually obtained by depositing a sacrificial layer, such as phosphorosilicate glass (for example, PSG) combined with a liquid etchant (for example, liquid hydrofluoric acid) or a gaseous etchant (such as, gaseous hydrofluoric acid) as well as a certain proportion of buffer substances (such as, ammonium fluoride), and releasing the above materials. In a process of forming respective structural layers of the resonator, a structural stress may be accumulated in the structure. In addition, considerable heat may be generated during a reaction between the etchant and the sacrificial layer to form a thermal stress. Therefore, after the sacrificial layer is consumed by the etchant, the stress described above may lead to bonding of the two layers of electrodes 50 and 70 for forming the air gap. When the bonding occurs and the resonator operates, acoustic energy may continuously escape from a sandwich structure into the top electrode 70 through a bonding interface CT in FIG. 8, resulting in decrease in the Q-value. Meanwhile, the bonding may produce an impedance mismatch region with an uncontrollable shape, thus generating a large number of parasitic modes in the resonator. In addition, the bonding may form a mass load, which will cause a frequency shift (frequency drop) of the resonator. Therefore, the bonding may eventually lead to deterioration of resonator performance.

The top electrodes of the resonator in FIG. 2 have the air gap 60, and the first top electrode 50 (i.e., a lower electrode layer) and the second top electrode 70 (i.e., an upper electrode layer) are located on both sides of the air gap 60, respectively. The second top electrode 70 protrudes upwardly away from the first top electrode 50 under the action of the stress, thereby avoiding or reducing possibility of bonding to the first top electrode 50.

Therefore, the present disclosure provides a resonator structure based on stress formation, in which electrode layers or the sandwich structure of the resonator is bent under the action of the stress. In this way, the electrodes on both sides for forming the air gap are arranged away from each other, to inhibit or avoid electrode bonding.

The gap electrode structure of the present disclosure is realized by stresses and without additional materials and structures. Negative influence of additional materials and structures on acoustic performance of the resonator can be avoided, and meanwhile the material cost can be reduced, processing procedures can be reduced, and a production efficiency can be improved.

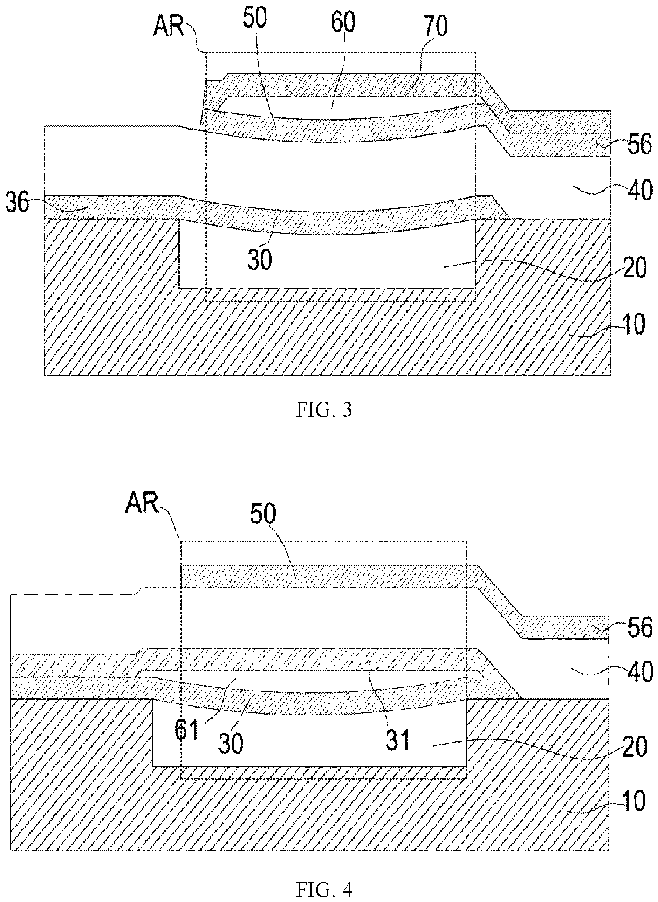

FIG. 3 is a schematic sectional view along line A1-A2 in FIG. 1 according to another exemplary embodiment of the present disclosure, in which top electrodes are provided with a gap layer and a lower electrode layer of the top electrodes protrudes downwardly. The top electrodes of the resonator of FIG. 3 has an air gap 60, and the first top electrode 50 and the second top electrode 70 are located respectively on both sides of the air gap 60. The first top electrode 50 is depressed downwardly away from the second top electrode 70 under action of a stress, thereby avoiding or reducing possibility of bonding to the second top electrode 70.

FIG. 4 is a schematic sectional view along line A1-A2 in FIG. 1 according to an exemplary embodiment of the present disclosure, in which bottom electrodes are provided with a gap layer and a lower electrode layer of the bottom electrodes protrudes downwardly. The bottom electrodes of the resonator in FIG. 4 has an air gap 61, and the first bottom electrode 30 and the second bottom electrode 31 are located respectively on both sides of the air gap 61. The first bottom electrode 30 is depressed downwardly away from the second bottom electrode 31 under action of the stress, thereby avoiding or reducing possibility of bonding to the second bottom electrode 31.

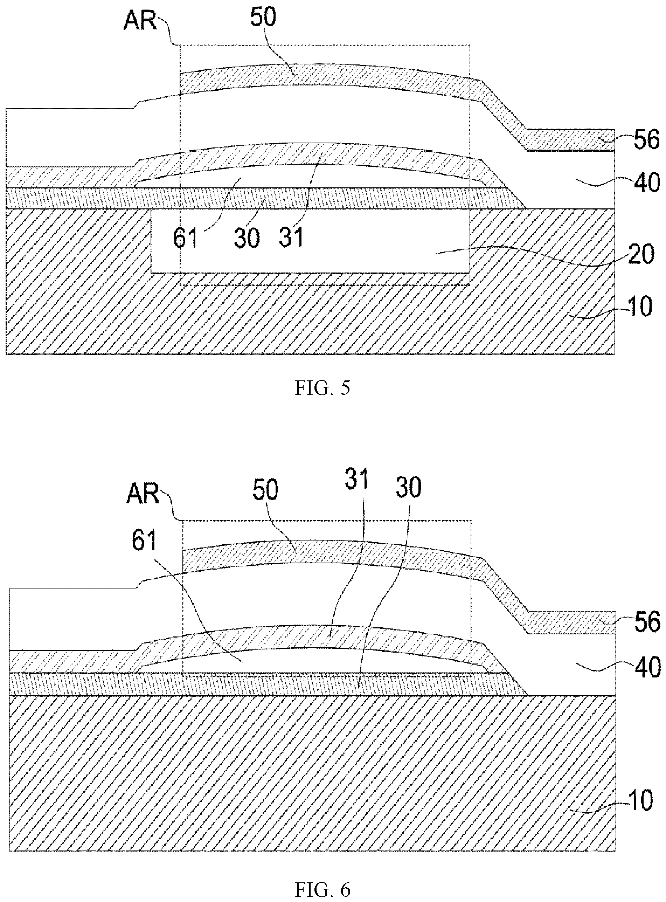

FIG. 5 is a schematic sectional view along line A1-A2 in FIG. 1 according to an exemplary embodiment of the present disclosure, in which bottom electrodes are provided with a gap layer and an upper electrode layer of the bottom electrodes protrudes upwardly. The bottom electrodes of the resonator in FIG. 5 has an air gap 61, and the first bottom electrode 30 and the second bottom electrode 31 are located respectively on both sides of the air gap 61. A sandwich structure formed by the second bottom electrode 31, a piezoelectric layer 40, and the top electrode 50 bulges upwardly away from the first bottom electrode 30 under action of the stresses, such that the second bottom electrode 31 and the first bottom electrode 30 can be prevented from bonding to each other.

FIG. 6 is a schematic sectional view along line A1-A2 in FIG. 1 according to an exemplary embodiment of the present disclosure, in which bottom electrodes are provided with a gap layer as an acoustic mirror structure, and an upper electrode layer of the bottom electrodes protrudes upwardly. In the resonator structure of FIG. 6, there is not provided with the acoustic mirror cavity 20, and the air gap 61 is configured to reflect sound waves. In addition, since a contact area between the first bottom electrode 30 and the substrate 10 is increased, the second bottom electrode 31 can be more firm during the stress deformation.

FIG. 7 is a schematic sectional view along line A1-A2 in FIG. 1 according to an exemplary embodiment of the present disclosure, in which bottom electrodes are provided with a gap layer and top electrodes are provided with a gap layer. Air gap structures 60 and 61 are respectively included in the top electrode and bottom electrode in the resonator structure of FIG. 7. The first bottom electrode 30 and the second bottom electrode 31 are located respectively on both sides of the air gap 61, while the first top electrode 50 and the second top electrode 70 are located respectively on both sides of the air gap 60. Under action of the stress, the first bottom electrode 30 is depressed downwardly away from the second bottom electrode 31, and the second top electrode 70 bulges upwardly away from the first top electrode 50.

In the present disclosure, a gap layer is provided in the top electrode and/or the bottom electrode of the bulk acoustic wave resonator. The air gap located in the electrode can effectively reflect acoustic waves, and greatly reduce energy of the acoustic waves entering an additional electrode on a side away from the piezoelectric film (or the piezoelectric layer), to effectively suppress or eliminate negative effects of the additional electrode due to its participation in acoustic vibration. In addition, the upper and lower electrodes enclosing the air gap can form a parallel circuit structure, which can effectively reduce the electrical loss of the resonator and improve the Q-value of the resonator, especially the Q-value at and near the series resonant frequency.

Therefore, the additional electrode, i.e. an electrode layer arranged away from the piezoelectric layer, is acoustically decoupled from the resonator cavity due to existence of the air gap since most of the acoustic waves are reflected back to the resonator at the air gap and thus do not enter the additional electrode. The existence and parameter changes of the additional electrode do not affect other key parameters (such as, a resonant frequency, and an electromechanical coupling coefficient) of the resonator except for the Q-value.

Compared with a structure in which the air gap is located between the piezoelectric layer and the electrode, in the present disclosure, parasitic series capacitance caused by the air gap is avoided, and the electromechanical coupling coefficient kt² of the resonator does not degrade. Compared with a structure in which the temperature compensation interlayer (such as, silicon dioxide) is located between two layers of electrodes, the air gap or vacuum gap of the present disclosure causes the resonant frequency of the resonator unchanged, other key parameters such as the Q-value and the electromechanical coupling coefficient does not degrade, and the Q-value at and near the series resonant frequency can be improved.

In the present disclosure, the electrode with the gap layer is a gap electrode.

In the present disclosure, when the acoustic mirror structure is arranged in the substrate and no gap layer is arranged in the bottom electrode, the effective region of the resonator is an overlapping region of the top electrode, the piezoelectric layer, the bottom electrode, and the acoustic mirror in a thickness direction of the resonator.

In the present disclosure, when a gap layer is provided in the bottom electrode, the effective region of the resonator is an overlapping region of the top electrode, the bottom electrode, the piezoelectric layer, and the gap layer of the bottom electrode in the thickness direction of the resonator.

A numerical range mentioned in the present disclosure encompass not only end values, but also a median value or other values between the end values, all of which fall within the scope of the present disclosure.

As can be understood by those skilled in the art, the bulk acoustic wave resonator according to the present disclosure can be configured to form a filter.

In view of the above, the present disclosure provides following technical solutions.
1. A bulk acoustic wave resonator includes:
   a substrate;
   an acoustic mirror;
   a bottom electrode;
   a top electrode; and
   a piezoelectric layer provided between the bottom electrode and the top electrode;
   wherein
   the bottom electrode and/or the top electrode is a gap electrode, the gap electrode has a gap layer, the gap layer is provided with an upper electrode layer on an upper side thereof and a lower electrode layer on a lower side thereof, the gap layer is arranged between the upper electrode layer and the lower electrode layer in a thickness direction of the resonator, and the upper electrode layer and the lower electrode layer are electrically connected to each other in parallel at both ends of the gap layer; and
   one of the upper electrode layer and the lower electrode layer is an arc-shaped electrode layer, and the arc-shaped electrode layer has a radian away from another one of the upper electrode layer and the lower electrode layer in the thickness direction of the resonator.
2. The resonator according to 1, wherein
   the gap layer is an air gap layer or a vacuum gap layer.
3. The resonator according to 1, wherein
   the gap layer has a thickness in a range of 50 Å to 10000 Å.
4. The resonator according to 3, wherein
   the gap layer has a thickness in a range of 100 Å to 5000 Å.
5. The resonator according to any one of 1 to 4, wherein
   the top electrode is the gap electrode.
6. The resonator according to 5, wherein
   the upper electrode layer is the arc-shaped electrode layer.
7. The resonator according to 5, wherein
   the lower electrode layer is the arc-shaped electrode layer.
8. The resonator according to 7, wherein
   the acoustic mirror is an acoustic mirror cavity; and
   the bottom electrode has an arc shape protruding toward inside of the acoustic mirror cavity.
9. The resonator according to any one of 1 to 4, wherein
   the bottom electrode is the gap electrode.
10. The resonator according to 9, wherein
   the acoustic mirror is an acoustic mirror cavity; and
   the lower electrode layer is the arc-shaped electrode layer protruding toward inside of the acoustic mirror cavity.
11. The resonator according to 9, wherein
   the upper electrode layer is the arc-shaped electrode layer protruding toward the piezoelectric layer.
12. The resonator according to 11, wherein
   the top electrode has an arc shape corresponding to a shape of the upper electrode layer.
13. The resonator according to 11, wherein
   the acoustic mirror is an acoustic mirror cavity.
14. The resonator according to 11, wherein
   the gap layer forms the acoustic mirror.
15. The resonator according to any one of 1 to 4, wherein
   the bottom electrode and the top electrode are both gap electrodes; and
   electrode layers of the two gap electrodes away from the piezoelectric layer are both arc-shaped electrode layers protruding away from the piezoelectric layer.
16. A filter includes the bulk acoustic wave resonator according to any one of 1 to 15.
17. An electronic device includes the filter according to 16 or the resonator according to any one of 1 to 15.

Although the embodiments of the present disclosure have been shown and described, it should be understood for those skilled in the art that modifications may be made to these embodiments without departing from the principle and spirit of the present disclosure, and the scope thereof is defined by the appended claims and their equivalents.

## Claims

1. A bulk acoustic wave resonator, comprising:
a substrate;
an acoustic mirror;
a bottom electrode;
a top electrode; and
a piezoelectric layer provided between the bottom electrode and the top electrode,
wherein the bottom electrode and/or the top electrode is a gap electrode, the gap electrode has a gap layer, the gap layer is provided with an upper electrode layer on an upper side thereof and a lower electrode layer on a lower side thereof, the gap layer is arranged between the upper electrode layer and the lower electrode layer in a thickness direction of the resonator, and the upper electrode layer and the lower electrode layer are electrically connected to each other in parallel at both ends of the gap layer; and
wherein one of the upper electrode layer and the lower electrode layer is an arc-shaped electrode layer, and the arc-shaped electrode layer has a radian away from another one of the upper electrode layer and the lower electrode layer in the thickness direction of the resonator.

2. The resonator according to claim 1, wherein the gap layer is an air gap layer or a vacuum gap layer.

3. The resonator according to claim 1, wherein the gap layer has a thickness in a range of 50 Å to 10000 Å.

4. The resonator according to claim 3, wherein the gap layer has a thickness in a range of 100 Å to 5000 Å.

5. The resonator according to any one of claims 1 to 4, wherein the top electrode is the gap electrode.

6. The resonator according to claim 5, wherein the upper electrode layer is the arc-shaped electrode layer.

7. The resonator according to claim 5, wherein the lower electrode layer is the arc-shaped electrode layer.

8. The resonator according to claim 7, wherein the acoustic mirror is an acoustic mirror cavity; and
the bottom electrode has an arc shape protruding toward inside of the acoustic mirror cavity.

9. The resonator according to any one of claims 1 to 4, wherein the bottom electrode is the gap electrode.

10. The resonator according to claim 9, wherein the acoustic mirror is an acoustic mirror cavity; and
the lower electrode layer is the arc-shaped electrode layer protruding toward inside of the acoustic mirror cavity.

11. The resonator according to claim 9, wherein the upper electrode layer is the arc-shaped electrode layer protruding toward the piezoelectric layer.

12. The resonator according to claim 11, wherein the top electrode has an arc shape corresponding to a shape of the upper electrode layer.

13. The resonator according to claim 11, wherein the acoustic mirror is an acoustic mirror cavity.

14. The resonator according to claim 11, wherein the gap layer forms the acoustic mirror.

15. The resonator according to any one of claims 1 to 4, wherein the bottom electrode and the top electrode are both gap electrodes; and
electrode layers of the two gap electrodes away from the piezoelectric layer are both arc-shaped electrode layers protruding away from the piezoelectric layer.

16. A filter, comprising the bulk acoustic wave resonator according to any one of claims 1 to 15.

17. An electronic device, comprising the filter according to claim 16 or the resonator according to any one of claims 1 to 15.
